Europäisches Patentamt

European Patent Office

Office européen des brevets

(11) Veröffentlichungsnummer: **0 210 525**
**A1**

(12) # EUROPÄISCHE PATENTANMELDUNG

(21) Anmeldenummer: 86109631.1

(22) Anmeldetag: 14.07.86

(51) Int. Cl.⁴: **H05K 7/18** , H05K 9/00

(30) Priorität: 26.07.85 DE 8521461 U

(43) Veröffentlichungstag der Anmeldung:
04.02.87 Patentblatt 87/06

(84) Benannte Vertragsstaaten:
DE GB

(71) Anmelder: **Siemens Aktiengesellschaft Berlin und München**
**Wittelsbacherplatz 2**
**D-8000 München 2(DE)**

(72) Erfinder: **Kalbitz, Wolfgang, Dipl.-Ing. (FH)**
**Rühlstrasse 18**
**D-8520 Erlangen(DE)**
Erfinder: **Zachmann, Robert**
**Frankenring 78a**
**D-8555 Adelsdorf(DE)**

(54) **Elektronikschrank.**

(57) Die Erfindung betrifft einen Elektronikschrank, der insbesondere in Verbindung mit einem Kernspintomographiegerät anwendbar ist. Das Gehäuse (1) ist aufgrund seiner Formgebung selbsttragend und der Tragrahmen (7) für die Elektronikkomponenten ist unmittelbar am Gehäuse (1) gelagert. Die metallischen Teile (2, 3, 6, 7, 9) können aus unmagnetischem Material, z.B. Aluminium, bestehen. Eine hochfrequenzdichte Ausführung ergibt sich, wenn der Schrank zwei miteinander verbundene, gewinkelte Teile (2, 3) aufweist, die mit einem Sockel (6) und einer Abdeckung (9) verbunden sind und eine Öffnung freilassen, die durch eine Frontplatte verschlossen ist, wobei in die Fugen zwischen Frontplatte und den übrigen Gehäuseteilen (2, 3, 6, 9) eine Hochfrequenzdichtung eingelegt ist.

FIG 1

## Elektronikschrank

Die Erfindung betrifft einen Elektronikschrank mit einem Gehäuse und einem darin um eine vertikale Achse schwenkbar gelagerten Tragrahmen für Elektronikkomponenten.

Bekannte Elektronikschränke dieser Art weisen im Innern einen feststehenden Rahmen auf, an dem der schwenkbare Tragrahmen gelagert ist. Dieser Rahmen ist durch Bleche nach außen verkleidet.

Der Erfindung liegt die Aufgabe zugrunde, den Aufbau eines Elektronikschrankes gegenüber dem Stand der Technik zu vereinfachen, insbesondere eine Konstruktion zu finden, bei der ein gesonderter Rahmen für die Lagerung des Tragrahmens überflüssig ist.

Diese Aufgabe ist erfindungsgemäß dadurch gelöst, daß das Gehäuse aufgrund seiner Formgebung selbsttragend und der Tragrahmen unmittelbar am Gehäuse gelagert ist. Bei dem erfindungsgemäßen Elektronikschrank weist das aus Blech bestehende Gehäuse aufgrund von abgeknickten Teilen eine derartige Form auf, daß seine Steifheit für die Lagerung des Tragrahmens ausreicht.

Der erfindungsgemäße Elektronikschrank eignet sich insbesondere zur Anwendung in Verbindung mit einem Kernspintomographiegerät. Für seine Aufstellung in der Untersuchungskabine ist es dabei zweckmäßig, die metallischen Teile aus unmagnetischem Material, insbesondere Aluminium, herzustellen. Für eine ausreichende Stabilität und eine hochfrequenzdichte Ausbildung, die in der Kernspintomographie erforderlich ist, kann der Schrank zwei miteinander verbundene, gewinkelte Teile aufweisen, die eine Öffnung feilassen, die durch eine Frontplatte verschlossen ist, wobei in die Fugen zwischen Frontplatte und diese beiden Teile eine Hochfrequenzdichtung, vorzugsweise aus unmagnetischem Drahtgeflecht, eingelegt ist.

Die Erfindung ist nachfolgend anhand eines in der Zeichnung dargestellten Ausführungsbeispieles näher erläutert.

Es zeigen:

Fig. 1 und 2 eine Vorderansicht und eine Draufsicht eines Elektronikschrankes nach der Erfindung, und

Fig. 3 eine perspektivische Ansicht des Elektronikschrankes gemäß den Figuren 1 und 2.

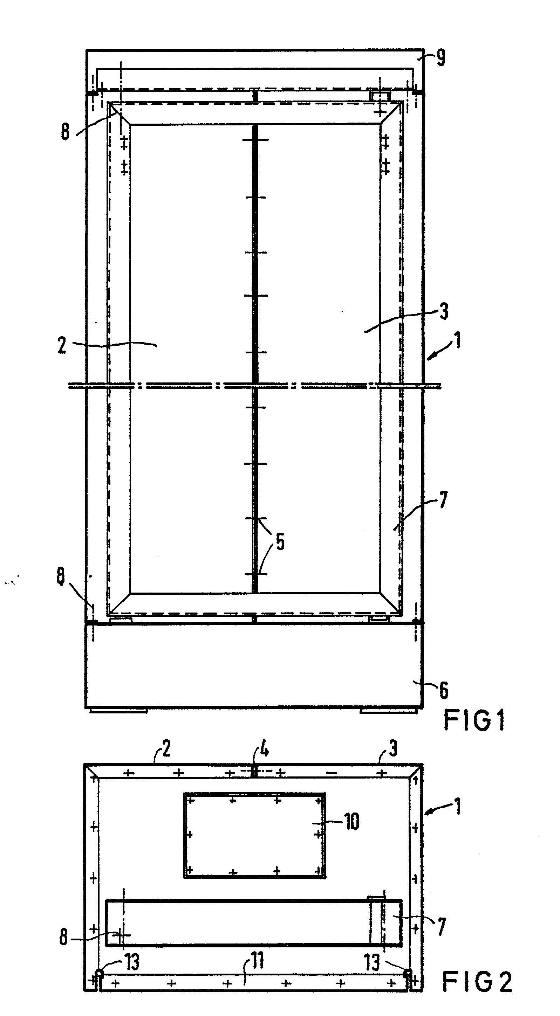

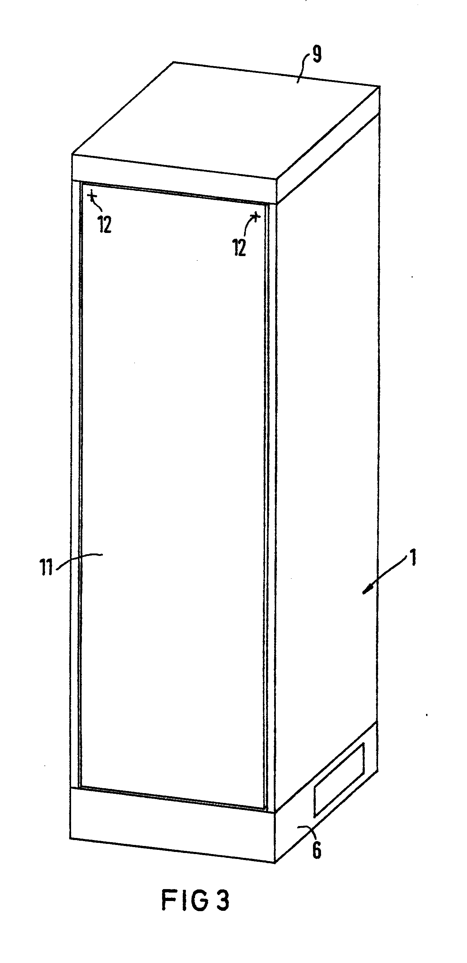

Der in den Figuren 1 bis 3 dargestellte Elektronikschrank weist ein Gehäuse 1 mit zwei gewinkelten Blechteilen 2 und 3 auf, welche längs einer vertikalen Fuge 4 an den Stellen 5 miteinander verschraubt sind. Die Blechteile 2 und 3 sind ferner mit einem Sockel 6 und einer Abdeckung 9 verschraubt.

Das Gehäuse 1 ist aufgrund der Formgebung der Blechteile 2 und 3 selbsttragend und steif genug, um einen Tragrahmen 7 tragen zu können, der am Gehäuse 1, und zwar am Blechteil 2, um eine vertikale Achse 8 schwenkbar gelagert ist. Der Tragrahmen 7 dient zur Aufnahme nicht dargestellter Elektronikkomponenten und weiterer Komponenten, wie z.B. von Magnetventilen. Der Elektronikschrank ist auf seiner Oberseite durch die Abdeckung 9, die in der Figur 2 nicht dargestellt ist, geschlossen.

Alle Teile 2, 3, 6, 9 bestehen aus Aluminiumblech, also aus unmagnetischem Material. Auch der Tragrahmen 7 besteht aus Aluminium, so daß der gesamte Elektronikschrank unmagnetisch ist und sich zur Anwendung in Verbindung mit einem Kernspintomographiegerät eignet.

Nach der Bestückung des Elektronikschrankes mit seinen Komponenten unter Einführung der Kabel vom Sockel 6 aus durch eine in der Figur 2 dargestellte Öffnung 10 wird der Elektronikschrank auf seiner Vorderseite durch eine Frontplatte 11 aus Aluminiumblech verschlossen. Die Frontplatte 11 wird an den Stellen 12 angeschraubt und an ihrer Unterseite in entsprechend geformte Ansätze der Blechteile 2 und 3 eingehängt. Für eine hochfrequenzdichte Kapselung der Elektronikkomponenten auf dem Tragrahmen 7 ist in die Fugen zwischen der Frontplatte 11, den Blechteilen 2 und 3, dem Sockel 6 und die Abdeckung 9 jeweils eine Hochfrequenzdichtung eingelegt. In der Figur 2 ist dabei die Hochfrequenzdichtung 13 sichtbar. Zur hochfrequenten Abdichtung kann ein unmaganetisches Drahtgeflecht in Form eines Schlauches Verwendung finden, das an den die Fugen begrenzenden Blechteilen anliegt.

### Ansprüche

1. Elektronikschrank mit einem Gehäuse (1) und einem darin um eine vertikale Achse (8) - schwenkbar gelagerten Tragrahmen (7) für Elektronikkomponenten, **dadurch gekennzeichnet**, daß das Gehäuse (1) aufgrund seiner Formgebung selbsttragend und der Tragrahmen (7) unmittelbar am Gehäuse (1) gelagert ist.

2. Elektronikschrank nach Anspruch 1, **dadurch gekennzeichnet**, daß die metallischen Teile (2, 3, 6, 7, 9) aus unmagnetischem Material bestehen.

3. Elektronikschrank nach Anspruch 1 oder 2, **gekennzeichnet durch** zwei miteinander verbundene, gewinkelte Blechteile (2, 3), die mit einem Sockel (6) und einer Abdeckung (9) verbunden sind und eine Öffnung freilassen, die durch eine Frontplatte (11) verschlossen ist, wobei in die Fugen zwischen Frontplatte (11) und den übrigen Gehäuseteilen (2, 3, 6, 9) eine Hochfrequenzdichtung (13) eingelegt ist.

4. Elektronikschrank nach Anspruch 3, **dadurch gekennzeichnet**, daß die Hochfrequenzdichtung (13) unmagnetisches Drahtgeflecht aufweist.

FIG 1

FIG 2

FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | DE-A-2 738 399 (SIEMENS) <br> * Seite 5, Zeilen 6-16 * | 1 | H 05 K 7/18 <br> H 05 K 9/00 |
| Y | DE-A-2 316 933 (SIEMENS) <br> * Seite 2, Absatz 3 * | 1 | |
| A | | 3 | |
| A | US-A-3 982 058 (HILL) <br> * Spalte 2, Zeilen 57,58 * | 2 | |
| A | FR-A-1 589 088 (DUCROS) <br> * Seite 1, Zeilen 33-40 * | 4 | |

RECHERCHIERTE SACHGEBIETE (Int. Cl.4)

H 05 K

Der vorliegende Recherchenbericht wurde für alle Patentansprüche erstellt.

| Recherchenort | Abschlußdatum der Recherche | Prüfer |
|---|---|---|
| DEN HAAG | 03-11-1986 | TOUSSAINT F.M.A. |